# EUROPÄISCHE PATENTSCHRIFT

(11) **EP 2 100 305 B1**
(45) Veröffentlichungstag und Bekanntmachung des Hinweises auf die Patenterteilung: **29.06.2011**
(21) Anmeldenummer: 07821310.5
(22) Anmeldetag: 15.10.2007
(51) Int. Cl.: G11C 5/14, G06K 19/077

(54) **MOBILE DATENSPEICHERVORRICHTUNG**
MOBILE DATA STORAGE DEVICE
DISPOSITIF PORTABLE DE MÉMORISATION DE DONNÉES

(30) Priorität: 11.12.2006 DE 102006058352
(43) Veröffentlichungstag der Anmeldung: 16.09.2009
(73) Patentinhaber: Siemens Aktiengesellschaft, 80333 München (DE)
(72) Erfinder: BUSSER, Jens-Uwe, 81739 München (DE); OTTO, Martin, 81737 München (DE)
(86) Internationale Anmeldenummer: PCT/EP2007/060943
(87) Internationale Veröffentlichungsnummer: WO 2008/071478

(56) Entgegenhaltungen:
- EP-A- 0 977 145
- WO-A-01/09954
- WO-A-01/15061

## Beschreibung

Die Erfindung betrifft eine mobile Datenspeichervorrichtung, die als Datenspeicherkarte oder Datenspeicherstick ausgebildet ist.

Die WO 01/09954 A1 offenbart eine aktive Folie für Chipkarten mit Display. Optische Anzeigeelemente und elektronische Ansteuerungsbestandteile sind mittels organischer Halbleitermaterialien nebeneinander auf einer Kunststofffolie ausgebildet. Ferner ist als eine Energiequelle eine Solarzelle vorgesehen.

In der EP 0 977 145 A2 ist eine Funkchipkarte offenbart. Diese weist einen Trägerkörper, einen integrierten Schaltkreis, eine Kommunikationsantenne und eine Energieversorgungsantenne auf. Die Antennen sind mit dem integrierten Schaltkreis verbunden. In der Energieversorgungsantenne ist in dem Trägerkörper ein Hohlraum ausgebildet, in dem ein plattenförmiger Permanentmagnet in Richtung einer Zentralachse der Energieversorgungsantenne bewegbar angeordnet ist.

In der WO 01/15061 A2 ist eine Chipkarte für kontaktlose Energieversorgung offenbart. Die Chipkarte weist mindestens ein sich senkrecht durch ihre Hauptflächen ersteckendes Loch auf, um das herum jeweils eine Antennenspule in die Chipkarte eingebaut ist. Ein Stift mit einer zum Beispiel batteriebetriebenen Energie-/Sendespule ist für einen Betrieb eines kontaktlosen Transpondersystems durch das Loch in der Chipkarte steckbar, wobei eine induktive Kopplung und eine effektive Energieversorgung der Chipkarte resultiert.

Die Aufgabe der Erfindung ist, eine mobile Datenspeichervorrichtung zu schaffen, die einfach ist und bei der die benötigte elektrische Energie jederzeit nach Bedarf erzeugbar ist.

Die Aufgabe wird gelöst durch die Merkmale der unabhängigen Patentansprüche. Vorteilhafte Weiterbildungen der Erfindung sind in den Unteransprüchen gekennzeichnet.

Gemäß einem ersten Aspekt zeichnet sich die Erfindung aus durch eine mobile Datenspeichervorrichtung, die als Datenspeicherkarte oder als Datenspeicherstick ausgebildet ist. Die mobile Datenspeichervorrichtung umfasst mindestens eine elektrische Spule, einen Energiespeicher, einen Datenspeicher, mindestens eine Schnittstelleneinheit und mindestens einen Permanentmagneten. Die mindestens eine Schnittstelleneinheit ist ausgebildet zum Ausgeben oder zum Aufnehmen von Daten, die in dem Datenspeicher gespeichert oder speicherbar sind. Der Energiespeicher ist induktiv aufladbar durch ein magnetisches Wechselfeld, das erzeugbar ist durch ein Bewegen des mindestens einen Permanentmagneten in einem Bereich der elektrischen Spule. Mindestens eine der mindestens einen Schnittstelleneinheit ist für deren Energieversorgung elektrisch mit dem Energiespeicher gekoppelt. Der mindestens eine Permanentmagnet ist mit einem Schieber gekoppelt, durch den der mindestens eine Permanentmagnet geradlinig durch oder über die mindestens eine elektrische Spule bewegbar ist.

Der Vorteil ist, dass zumindest eine Teilfunktionalität oder eine Zusatzfunktionalität der mobilen Datenspeichervorrichtung auch dann genutzt werden kann, wenn diese nicht mit einer externen und gegebenenfalls stationären Schreib-Leseeinheit gekoppelt ist, durch die die mobile Datenspeichervorrichtung gegebenenfalls mit elektrischer Energie versorgbar ist. Die benötigte elektrische Energie ist jederzeit nach Bedarf erzeugbar. Durch die daraus resultierende Unabhängigkeit von externen Energiequellen bleibt die Mobilität bei dem Nutzen der mobilen Datenspeichervorrichtung gewahrt. Ferner müssen auch keine Batterien vorgesehen sein und gegebenenfalls ausgetauscht werden, wenn diese erschöpft sind. Dadurch ist eine insgesamt längere Nutzungsdauer der mobilen Datenspeichervorrichtung möglich.

Ein weiterer Vorteil ist, dass eine solche mobile Datenspeichervorrichtung einfach ist. Der Schieber ist beispielsweise ausgebildet für eine manuelle Bedienung, zum Beispiel zum Hin- und Herschieben des Schiebers mit einem Finger. Der Schieber kann jedoch auch beispielsweise so ausgebildet sein, dass der Schieber und somit auch der mindestens eine Permanentmagnet durch Schütteln der mobilen Datenspeichervorrichtung hin- und herbewegbar ist.

Gemäß einem zweiten Aspekt zeichnet sich die Erfindung aus durch eine mobile Datenspeichervorrichtung, die als Datenspeicherkarte oder als Datenspeicherstick ausgebildet ist. Die mobile Datenspeichervorrichtung umfasst mindestens eine elektrische Spule, einen Energiespeicher, einen Datenspeicher, mindestens eine Schnittstelleneinheit und mindestens einen Permanentmagneten. Die mindestens eine Schnittstelleneinheit ist ausgebildet zum Ausgeben oder zum Aufnehmen von Daten, die in dem Datenspeicher gespeichert oder speicherbar sind. Der Energiespeicher ist induktiv aufladbar durch ein magnetisches Wechselfeld, das erzeugbar ist durch ein Bewegen des mindestens einen Permanentmagneten in einem Bereich der elektrischen Spule. Mindestens eine der mindestens einen Schnittstelleneinheit ist für deren Energieversorgung elektrisch mit dem Energiespeicher gekoppelt. Der mindestens eine Permanentmagnet ist mit einem Antriebsrad gekoppelt, durch das der mindestens eine Permanentmagnet kreisförmig über die elektrische Spule oder an dieser vorbei bewegbar ist.

Der Vorteil ist, dass zumindest eine Teilfunktionalität oder eine Zusatzfunktionalität der mobilen Datenspeichervorrichtung auch dann genutzt werden kann, wenn diese nicht mit einer externen und gegebenenfalls stationären Schreib-Leseeinheit gekoppelt ist, durch die die mobile Datenspeichervorrichtung gegebenenfalls mit elektrischer Energie versorgbar ist. Die benötigte elektrische Energie ist jederzeit nach Bedarf erzeugbar. Durch die daraus resultierende Unabhängigkeit von externen Energiequellen bleibt die Mobilität bei dem Nutzen der mobilen Datenspeichervorrichtung gewahrt. Ferner müssen auch keine Batterien vorgesehen sein und gegebenenfalls ausgetauscht werden, wenn diese erschöpft sind. Dadurch ist eine insgesamt längere Nutzungsdauer der mobilen Datenspeichervorrichtung möglich.

Ein weiterer Vorteil ist, dass eine solche mobile Datenspeichervorrichtung einfach ist. Das Antriebsrad ist beispielsweise ausgebildet für eine manuelle Bedienung, zum Beispiel mittels eines Drehknopfs oder mittels eines durch das Antriebsrad gesteckten Fingers, Bleistifts oder anderen geeigneten Gegenstands.

In einer weiteren vorteilhaften Ausgestaltung umfasst mindestens eine der mindestens einen Schnittstelleneinheit eine optische oder akustische Anzeige, die mittels Energie aus dem Energiespeicher betreibbar ist. Dies ermöglicht eine Zusatzfunktionalität der mobilen Datenspeichervorrichtung basierend auf der optischen oder akustischen Anzeige. Beispielsweise ist ein Energieinhalt des Energiespeichers anzeigbar oder ob der Energieinhalt des Energiespeichers für den vorgesehenen Betrieb der mobilen Datenspeichervorrichtung ausreicht. Ferner kann die optische oder akustische Anzeige beispielsweise dazu genutzt werden, einen Status einer Kommunikation, zum Beispiel einen Beginn, ein Ende oder einen Fehler, anzuzeigen oder einen Speicherinhalt des Datenspeichers anzuzeigen.

In einer weiteren vorteilhaften Ausgestaltung umfasst mindestens eine der mindestens einen Schnittstelleneinheit eine Sende- und/oder Empfangseinheit, die mittels Energie aus dem Energiespeicher betreibbar ist. Durch die in dem Energiespeicher gespeicherte elektrische Energie ist eine größere Reichweite für die Kommunikation der mobilen Datenspeichervorrichtung über diese Sende- und/oder Empfangseinheit erreichbar.

In einer weiteren vorteilhaften Ausgestaltung ist die mindestens eine elektrische Spule flächig ausgebildet. Dies hat den Vorteil, dass die mobile Datenspeichereinheit sehr flach ausbildbar und einfach herstellbar ist. Durch das flache Ausbilden der mindestens einen elektrischen Spule ist die mobile Datenspeichervorrichtung insbesondere als eine Chipkarte oder Smartcard ausbildbar und insbesondere als eine radiofreqenzidentifikationsbasierte Chipkarte oder Smartcard ohne äußerlich zugängliche elektrische Kontakte ausbildbar.

Ausführungsbeispiele der Erfindung sind im Folgenden anhand der schematischen Zeichnungen erläutert. Es zeigen:
- Figur 1: eine mobile Datenspeichervorrichtung,
- Figur 2: eine erste Ausführungsform der mobilen Datenspei- chervorrichtung,
- Figur 3: eine zweite Ausführungsform der mobilen Datenspei- chervorrichtung,
- Figur 4: eine dritte Ausführungsform der mobilen Datenspei- chervorrichtung und
- Figur 5: eine vierte Ausführungsform der mobilen Datenspei- chervorrichtung.

Elemente gleicher Konstruktion oder Funktion sind figurenübergreifend mit den gleichen Bezugszeichen versehen.

Eine mobile Datenspeichervorrichtung ist als eine Datenspeicherkarte oder als ein Datenspeicherstick ausgebildet. Insbesondere ist die mobile Datenspeichervorrichtung als eine Chipkarte oder Smartcard oder als ein USB-Datenspeicherstick ausgebildet. Die Chipkarte oder Smartcard weist beispielsweise von außen zugängliche Kontaktflächen auf. Eine Schreib-Leseeinheit, in die die Chipkarte oder Smartcard einsteckbar ist, ist ausgebildet zum Kontaktieren dieser Kontaktflächen und zum Versorgen der mobilen Datenspeichervorrichtung mit elektrischer Energie. Ferner erfolgt eine Kommunikation und ein Datenaustausch zwischen dem Schreib-Lesegerät und der mobilen Datenspeichervorrichtung über die Kontaktflächen. Die mobile Datenspeichervorrichtung kann jedoch auch alternativ oder zusätzlich für kontaktloses Kommunizieren oder kontaktlosen Datenaustausch mittels RFID ausgebildet sein. Elektrische Energie für den Betrieb der mobilen Datenspeichervorrichtung wird dabei einem elektromagnetischen Wechselfeld entnommen, das von der entsprechend ausgebildeten Schreib-Leseeinheit erzeugbar ist.

Steht jedoch keine Schreib-Leseeinheit zur Verfügung, aus dem die mobile Datenspeichervorrichtung die elektrische Energie für ihren Betrieb beziehen kann, ist der Betrieb der mobilen Datenspeichervorrichtung nur möglich, wenn diese über eine eigene Energiequelle verfügt. Eine solche Energiequelle kann beispielsweise eine Batterie, ein Akku, oder eine Solarzelle sein. Jedoch ist eine Lebensdauer einer Batterie begrenzt und ein Akku muss regelmäßig aufgeladen werden, um genügend Energie für den Betrieb der mobilen Datenspeichervorrichtung bereitstellen zu können. Für die Nutzung einer Solarzelle als Energiequelle muss genügend Licht vorhanden sein.

Als eine von dem Ladezustand einer Batterie oder eines Akkus und von einem Lichteinfall unabhängige Energiequelle ist ein Elektrogenerator oder Dynamo in der mobilen Datenspeichervorrichtung vorgesehen. Durch den Elektrogenerator oder den Dynamo wird mechanische Energie in elektrische Energie umgewandelt.

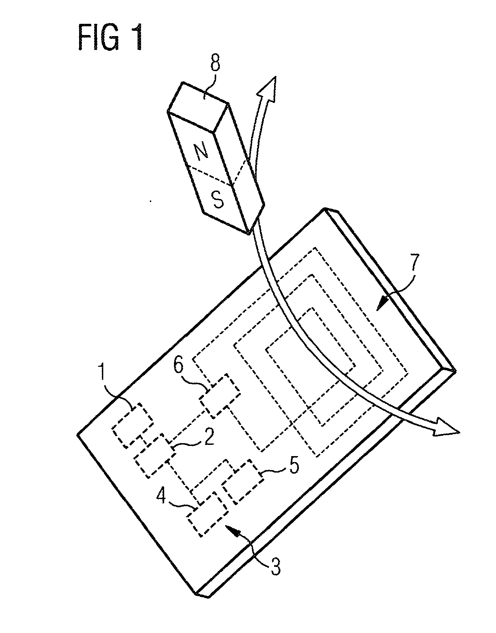

Die mobile Datenspeichervorrichtung umfasst einen Datenspeicher 1, eine Steuereinheit 2 und mindestens eine Schnittstelleneinheit 3 (Figur 1). Die mindestens eine Schnittstelleneinheit 3 ist beispielsweise als eine Sende- und/oder Empfangseinheit 4 und/oder als eine optische und/oder akustische Anzeige 5 ausgebildet. Es können auch weitere Schnittstelleneinheiten 3 vorgesehen sein, zum Beispiel eine Schnittstelle entsprechend einem Universal Serial Bus, kurz: USB, oder eine Schnittstelle für Radio Frequency Identification, kurz: RFID, oder eine andere Schnittstelle, die für die mobile Datenspeichervorrichtung nutzbar ist.

Die mobile Datenspeichervorrichtung umfasst ferner einen Energiespeicher 6, mindestens eine elektrische Spule 7 und mindestens einen Permanentmagneten 8. Die elektrische Spule 7 ist elektrisch mit dem Energiespeicher 6 gekoppelt, beispielsweise über einen nicht dargestellten Gleichrichter. Der Energiespeicher 6 ist beispielsweise ein Kondensator oder ein Akku. Durch Bewegen des mindestens einen Permanentmagneten 8 über der mindestens einen elektrischen Spule 7 ist in einem Bereich der mindestens einen elektrischen Spule 7 ein magnetisches Wechselfeld erzeugbar. Abhängig von dem magnetischen Wechselfeld ist der Energiespeicher 6 mit elektrischer Energie aufladbar, die mittels Induktion aus dem magnetischen Wechselfeld gewonnen werden kann.

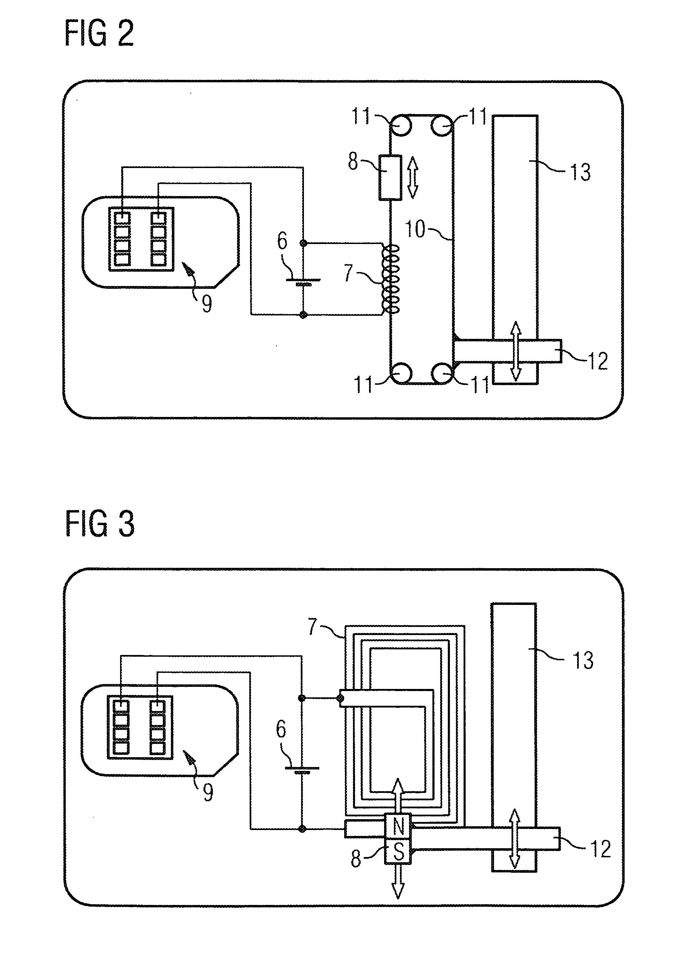

Figur 2 zeigt eine erste Ausführungsform der mobilen Datenspeichervorrichtung. Der Datenspeicher 1 und die Steuereinheit 2 und gegebenenfalls die mindestens eine Schnittstelleneinheit 3 sind in einem Modul 9 angeordnet. Das Modul 9 ist beispielsweise in einer Chipkarte oder Smartcard angeordnet. Der mindestens eine Permanentmagnet 8 ist mit einem Antriebsband 10 verbunden, das über Umlenkrollen 11 geführt ist und mit einem Schieber 12 verbunden ist. Mittels des Antriebsbands 10 ist der Permanentmagnet 8 durch die mindestens eine elektrische Spule 7 bewegbar. Die mobile Datenspeichervorrichtung weist vorzugsweise eine Ausnehmung 13 auf, durch die der Schieber 12 zugänglich ist. Der Schieber 12 ist beispielsweise manuell hin- und herschiebbar, wodurch der mindestens eine Permanentmagnet 8 entsprechend durch die elektrische Spule 7 gezogen wird. Die mobile Datenspeichervorrichtung kann jedoch auch so ausgebildet sein, dass der mindestens eine Permanentmagnet 8 beispielsweise durch Schütteln der mobilen Datenspeichervorrichtung durch die mindestens eine elektrische Spule 7 bewegbar ist.

Figur 3 zeigt als eine zweite Ausführungsform der mobilen Datenspeichervorrichtung eine Variante der ersten Ausführungsform, bei der der mindestens eine Permanentmagnet 8 unmittelbar mit dem Schieber 12 gekoppelt ist. Die elektrische Spule 7 ist flächig ausgebildet und kann in einer Ebene oder in mehreren Ebenen ausgebildet sein. Mittels des Schiebers 12 ist der Permanentmagnet 8 über die mindestens eine elektrische Spule 7 bewegbar. Die zweite Ausführungsform hat den Vorteil, dass das Antriebsband 10 und die Umlenkrollen 11 nicht erforderlich sind und ferner die mobile Datenspeichervorrichtung so besonders flach ausgebildet werden kann.

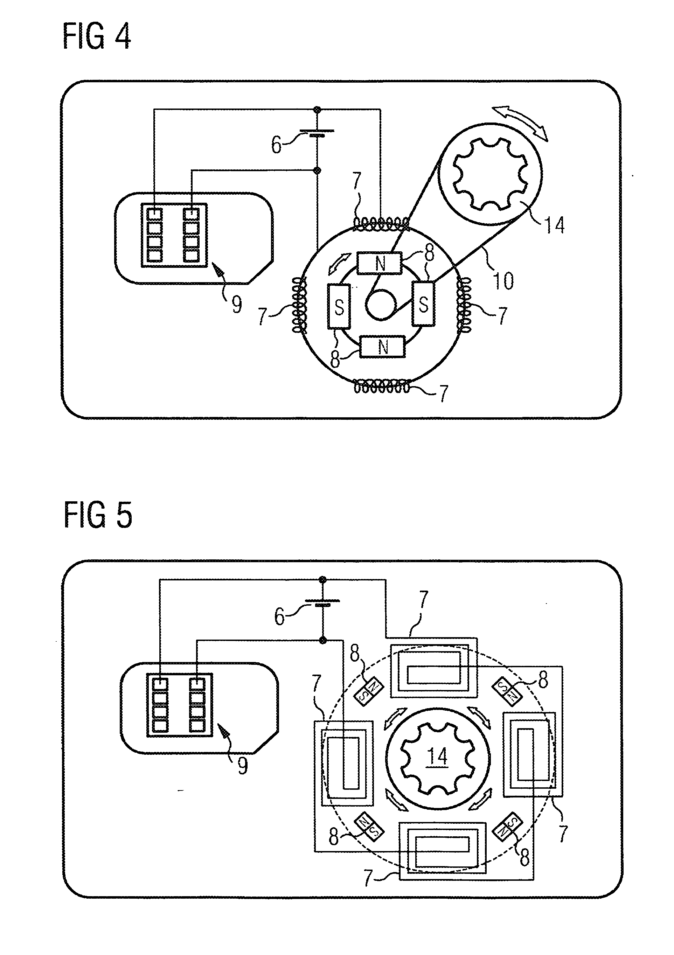

Figur 4 zeigt eine dritte Ausführungsform der mobilen Datenspeichervorrichtung. Bei der dritten Ausführungsform der mobilen Datenspeichervorrichtung ist anstatt des Schiebers 12 ein Antriebsrad 14 vorgesehen, das über das Antriebsband 10 den mindestens einen Permanentmagneten 8 rotatorisch über die mindestens eine elektrische Spule 7 oder an dieser vorbei bewegt. Die elektrische Spule 7 ist bevorzugt unterteilt in mehrere Teilspulen, die elektrisch in Reihe zueinander angeordnet sind. Die Teilspulen sind beispielsweise kreisförmig angeordnet, so dass der mindestens eine Permanentmagnet 8 in seiner rotatorischen Bewegung alle Teilspulen reihum passiert. Die mobile Datenspeichervorrichtung weist vorzugsweise eine kreisförmige Ausnehmung auf, durch die das Antriebsrad 14 von außerhalb der mobilen Datenspeichervorrichtung zugänglich ist. Bevorzugt ist das Antriebsrad 14 so ausgebildet, dass zum Beispiel ein Bleistift in das Antriebsrad 14 gesteckt werden kann und das Antriebsrad 14 durch Drehen der mobilen Datenspeichervorrichtung um den Bleistift oder durch Drehen des Bleistifts antreibbar ist. Dies entspricht dem Aufwickeln eines Tonbandes in einer Audiokompaktkassette mit Hilfe eines Bleistifts. Anstatt des Bleistifts kann gegebenenfalls auch ein anderer geeigneter Gegenstand oder ein Finger genutzt werden. Es kann jedoch auch ein Drehknopf oder eine Kurbel vorgesehen sein, der beziehungsweise die mit dem Antriebsrad 14 gekoppelt ist oder dieses umfasst.

Figur 5 zeigt als eine vierte Ausführungsform der mobilen Datenspeichervorrichtung eine Variante der dritten Ausführungsform. Die mindestens eine elektrische Spule 7 mit ihren Teilspulen ist flächig ausgebildet. Das Antriebsrad 14 ist so angeordnet, dass die Teilspulen der elektrischen Spule 7 das Antriebsrad 14 umgeben. Der mindestens eine Permanentmagnet 8 ist mit dem Antriebsrad 14 gekoppelt. Beispielsweise ist der mindestens eine Permanentmagnet 8 auf einer Scheibe angeordnet, in deren Zentrum das Antriebsrad 14 angeordnet ist und die mit diesem gekoppelt ist. Die vierte Ausführungsform hat den Vorteil, dass diese besonders flach ausgebildet werden kann und ferner mit wenigen Bauelementen herstellbar ist.

Die Energieversorgung der mobilen Datenspeichervorrichtung per Elektrogenerator oder Dynamo ist insbesondere vorteilhaft, wenn die mobile Datenspeichervorrichtung einen Prozessor umfasst, der beispielsweise durch die Steuereinheit 2 umfasst oder gebildet ist, und der Prozessor mit der erzeugten Energie betreibbar ist. Dadurch ist eine Zusatzfunktionalität der mobilen Datenspeichervorrichtung mobil und unabhängig von der Verfügbarkeit einer externen Schreib-Leseeinheit nutzbar. Die Zusatzfunktionalität umfasst beispielsweise ein Anzeigen von Informationen.

Die optische und/oder akustische Anzeige 5 ist beispielsweise ausgebildet zum Anzeigen einer in dem Energiespeicher 6 verfügbaren Energiemenge und/oder zum Anzeigen, ob die verfügbare Energiemenge für einen Betrieb der mobilen Datenspeichervorrichtung ausreicht. Ferner kann die optische und/oder akustische Anzeige 5 ausgebildet sein zum Anzeigen eines Speicherinhalts des Datenspeichers 1 und/oder zum Anzeigen eines Status eines Kommunikationsvorgangs, zum Beispiel eines Beginns oder eines Endes des Kommunikationsvorgangs oder gegebenenfalls des Auftretens eines Kommunikationsfehlers.

## Patentansprüche

1. Mobile Datenspeichervorrichtung, die als Datenspeicherkarte oder als Datenspeicherstick ausgebildet ist, die mindestens eine elektrische Spule (7), einen Datenspeicher (1), mindestens eine Schnittstelleneinheit (3) und mindestens einen Permanentmagneten (8) umfasst und die mindestens eine Schnittstelleneinheit (3) ausgebildet ist zum Ausgeben oder zum Aufnehmen von Daten, die in dem Datenspeicher (1) gespeichert oder speicherbar sind,
**dadurch gekennzeichnet**,
die mobile Datenspeichervorrichtung weiter einen Energiespeicher (6) umfasst, und der Energiespeicher (6) induktiv aufladbar ist durch ein magnetisches Wechselfeld, das erzeugbar ist durch ein Bewegen des mindestens einen Permanentmagneten (8) in einem Bereich der elektrischen Spule (7), und mindestens eine der mindestens einen Schnittstelleneinheit (3) für deren Energieversorgung elektrisch mit dem Energiespeicher (6) gekoppelt ist und der mindestens eine Permanentmagnet (8) mit einem Schieber (12) gekoppelt ist, durch den der mindestens eine Permanentmagnet (8) geradlinig durch oder über die elektrische Spule (7) bewegbar ist.

2. Mobile Datenspeichervorrichtung, die als Datenspeicherkarte oder als Datenspeicherstick ausgebildet ist, die mindestens eine elektrische Spule (7), einen Datenspeicher (1), mindestens eine Schnittstelleneinheit (3) und mindestens einen Permanentmagneten (8) umfasst und die mindestens eine Schnittstelleneinheit (3) ausgebildet ist zum Ausgeben oder zum Aufnehmen von Daten, die in dem Datenspeicher (1) gespeichert oder speicherbar sind,
**dadurch gekennzeichnet**,
die mobile Datenspeichervorrichtung weiter einen Energiespeicher (6) umfasst, und der Energiespeicher (6) induktiv aufladbar ist durch ein magnetisches Wechselfeld, das erzeugbar ist durch ein Bewegen des mindestens einen Permanentmagneten (8) in einem Bereich der elektrischen Spule (7), und mindestens eine der mindestens einen Schnittstelleneinheit (3) für deren Energieversorgung elektrisch mit dem Energiespeicher (6) gekoppelt ist und der mindestens eine Permanentmagnet (8) mit einem Antriebsrad (14) gekoppelt ist, durch das der mindestens eine Permanentmagnet (8) kreisförmig über die elektrische Spule (7) oder an dieser vorbei bewegbar ist.

3. Mobile Datenspeichervorrichtung nach einem der vorstehenden Ansprüche, bei der mindestens eine der mindestens einen Schnittstelleneinheit (3) eine optische oder akustische Anzeige (5) umfasst, die mittels Energie aus dem Energiespeicher (6) betreibbar ist.

4. Mobile Datenspeichervorrichtung nach einem der vorstehenden Ansprüche, bei der mindestens eine der mindestens einen Schnittstelleneinheit (3) eine Sende- und/oder Empfangseinheit (4) umfasst, die mittels Energie aus dem Energiespeicher (6) betreibbar ist.

5. Mobile Datenspeichervorrichtung nach einem der vorstehenden Ansprüche, bei der die elektrische Spule (7) flächig ausgebildet ist.

## Claims

1. Mobile data storage device which is embodied as a data memory card or data memory stick and which comprises at least one electric coil (7), a data memory (1), at least one interface unit (3) and at least one permanent magnet (8), and the at least one interface unit (3) is embodied for outputting or recording data which is or can be stored in the data memory (1),
**characterised in that**
the mobile data storage device additionally includes an energy store (6) and the energy store (6) is inductively chargeable by means of a magnetic alternating field which can be generated by moving the at least one permanent magnet (8) in a region of the electric coil (7), and at least one of the one or more interface units (3) is electrically coupled to the energy store (6) for its power supply and the at least one permanent magnet (8) is coupled to a slider (12) by means of which the at least one permanent magnet (8) can be moved in a straight line through or over the electric coil (7).

2. Mobile data storage device which is embodied as a data memory card or data memory stick and which comprises at least one electric coil (7), a data memory (1), at least one interface unit (3) and at least one permanent magnet (8), and the at least one interface unit (3) is embodied for outputting or recording data which is or can be stored in the data memory (1),
**characterised in that**
the mobile data storage device additionally includes an energy store (6) and the energy store (6) is inductively chargeable by means of a magnetic alternating field which can be generated by moving the at least one permanent magnet (8) in a region of the electric coil (7), and at least one of the one or more interface units (3) is electrically coupled to the energy store (6) for its power supply and the at least one permanent magnet (8) is coupled to a drive wheel (14) by means of which the at least one permanent magnet (8) can be moved in a circular motion over the electric coil (7) or past the latter.

3. Mobile data storage device according to one of the preceding claims, wherein at least one of the one or more interface units (3) includes an optical display or acoustic indicator (5) which can be powered by means of energy from the energy store (6).

4. Mobile data storage device according to one of the preceding claims, wherein at least one of the one or more interface units (3) includes a transmit and/or receive unit (4) which can be powered by means of energy from the energy store (6).

5. Mobile data storage device according to one of the preceding claims, wherein the electric coil (7) is embodied as planar.

## Revendications

1. Dispositif portable de stockage de données qui se présente sous la forme d'une carte de stockage de données ou d'une clé de stockage de données, comprenant au moins une bobine électrique (7), une mémoire de données (1), au moins une unité d'interface (3) et au moins un aimant permanent (8), et l'au moins une unité d'interface (3) étant réalisée pour produire en sortie ou pour recevoir des données qui sont ou peuvent être stockées dans la mémoire de données (1), **caractérisé en ce que** le dispositif portable de stockage de données comprend en outre un accumulateur d'énergie (6) et ledit accumulateur d'énergie (6) peut être chargé par induction par un champ magnétique alternatif qui peut être créé par un mouvement de l'au moins un aimant permanent (8) dans une zone de la bobine électrique (7), et au moins une de l'au moins une unité d'interface (3) étant couplée électriquement à l'accumulateur d'énergie (6) en vue de son approvisionnement en énergie et l'au moins un aimant permanent (8) étant couplé à un élément coulissant (12) qui permet de déplacer l'au moins un aimant permanent (8) en ligne droite à travers ou au-dessus de la bobine électrique (7).

2. Dispositif portable de stockage de données qui se présente sous la forme d'une carte de stockage de données ou d'une clé de stockage de données, comprenant au moins une bobine électrique (7), une mémoire de données (1), au moins une unité d'interface (3) et au moins un aimant permanent (8), et l'au moins une unité d'interface (3) étant réalisée pour produire en sortie ou pour recevoir des données qui sont ou peuvent être stockées dans la mémoire de données (1), **caractérisé en ce que** le dispositif portable de stockage de données comprend en outre un accumulateur d'énergie (6) et ledit accumulateur d'énergie (6) peut être chargé par induction par un champ magnétique alternatif qui peut être créé par un mouvement de l'au moins un aimant permanent (8) dans une zone de la bobine électrique (7), et au moins une de l'au moins une unité d'interface (3) étant couplée électriquement à l'accumulateur d'énergie (6) en vue de son approvisionnement en énergie et l'au moins un aimant permanent (8) étant couplé à une roue d'entraînement (14) par laquelle l'au moins un aimant permanent (8) peut être déplacé circulairement au-dessus de la bobine électrique (7) ou le long de celle-ci.

3. Dispositif mobile de stockage de données selon l'une des revendications précédentes, dans lequel au moins l'une de l'au moins une unité d'interface (3) comprend une signalisation optique ou acoustique (5) qu'il est possible de faire fonctionner au moyen d'énergie provenant de l'accumulateur d'énergie (6).

4. Dispositif mobile de stockage de données selon l'une des revendications précédentes, dans lequel au moins l'une de l'au moins une unité d'interface (3) comprend une unité émettrice et/ou réceptrice (4) qu'il est possible de faire fonctionner au moyen d'énergie provenant de l'accumulateur d'énergie (6).

5. Dispositif mobile de stockage de données selon l'une des revendications précédentes, dans lequel la bobine électrique (7) est de réalisation plane.
